# EUROPÄISCHE PATENTANMELDUNG

(11) **EP 0 873 913 A2**
(43) Veröffentlichungstag der Anmeldung: **28.10.1998**
(21) Anmeldenummer: 98106138.5
(22) Anmeldetag: 03.04.1998
(51) Int. Cl.: B60R 16/02

(54) **Verfahren zum Verhindern, Verringern oder Abstellen von Feuchtigkeitseinflüssen an elektronischen Baugruppen.**

(30) Priorität: 23.04.1997 DE 19717032
(71) Anmelder: TEMIC TELEFUNKEN microelectronic GmbH, 74072 Heilbronn (DE)
(72) Erfinder: Baur, Richard, 85276 Pfaffenhofen (DE); Fendt, Günter, 86529 Schrobenhausen (DE); Steinberger, Johann, 86529 Schrobenhausen (DE); Wöhrl, Alfons, 86529 Schrobenhausen (DE)
(74) Vertreter: Maute, Hans-Jürgen, Dipl.-Ing.

(57) **Zusammenfassung**

Ein Verfahren zum Verhindern oder Verringern von Feuchtigkeitseinflüssen in einem feuchtigkeitsgefährdeten Bereich einer elektrischen oder elektronischen Baugruppe ist dadurch gekennzeichnet, daß der feuchtigkeitsgefährdete Bereich erwärmt wird, derart, daß ein gebildeter Feuchtigkeitsniederschlag verdunstet oder das Entstehen eines Feuchtigkeitsniederschlags durch das Erwärmen verhindert wird. Eine Lackierung zum Verhindern des Zutritts von Feuchtigkeit ist nicht nötig.

## Beschreibung

Die Erfindung betrifft ein verfahren zum verhindern oder verringern von Feuchtigkeitseinflüssen an elektrischen oder elektronischen Baugruppen.

Die Erfindung betrifft auch eine Baugruppe ohne oder mit einer Leiterplatte, die elektrische und/oder elektronische Bauelemente beinhaltet, bei der und/oder bei denen an einem oder mehreren Mittel zum verhindern oder verringern von Feuchtigkeitseinflüssen von leitendem Material vorgesehen sind. Feuchtigkeitsempfindliche Baugruppen oder/und feuchtigkeitsgefährdete Bauteile bedürfen bei Anwendung des Verfahrens keines teuren hermetischen Verschlusses. Das Design der Baugruppe und/oder der Bauelemente ist so ausgesucht oder gestaltet, daß der Taupunkt über 0 °C z. B. auf der Oberfläche mit einer minimalen Energie verhinderbar ist.

Bei elektronischen Baugruppen im Kraftfahrzeugbereich, insbesondere bei elektronischen Steuergeräten, bei denen eine elektronische Schaltung auf einer Leiterplatte angeordnet ist, die auf einer Kunststoffplatte z.B. durch Ätzen erzeugte Leiterzüge trägt, werden schädliche Feuchtigkeitseinflüsse, wie z.B. Migration (Materialwanderung von leitfähigem Material) dadurch verringert oder verhindert, daß man die Leiterplatte oder die gesamte fertig aufgebaute Baugruppe lackiert, wodurch die leitfähigen Bereiche vor verschmutzung und dem Zutritt von Feuchtigkeit geschützt werden. Hierdurch wird z.B. Migration vollständig oder in ausreichendem Maß verhindert. Um die Wiederverwendung der Materialien einer Leiterplatte zu erleichtern, ist es jedoch vorteilhaft, wenn diese nicht lackiert sind. In einem derartigen Fall läßt sich die Baugruppe oder das elektronische Steuergerät dadurch hinreichend sicher vor dem Einfluß von Migration schützen, daß die gesamte Baugruppe in einem Gehäuse dicht eingeschlossen ist, was jedoch hohe Kosten verursacht.

Schädliche Feuchtigkeitseinflüsse basieren in der Regel auf der veränderten Leitfähigkeit und Feldstärke. Hierzu gehört auch die Migration, die Ihre Ursache in Spannungsdifferenzen zwischen benachbarten elektrischen Leitern hat. Dieser Vorgang wird vor allem durch Verunreinigungen, z.B. durch Flußmittelrückstände auf der Leiterplatte, und durch Feuchtigkeitsbildung auf der Leiterplatte unterstützt, wie sie insbesondere im Kraftfahrzeugbereich infolge der dort auftretenden sehr stark schwankenden Temperaturen vorkommen kann. Außerdem wird der Vorgang der Migration deswegen zunehmend bedeutsam, weil die elektronischen Komponenten, speziell hochintegrierte Schaltkreise, wie sogenannte ASICs, mit immer kleineren Pin-Abständen (Abstände der Anschlüsse) hergestellt werden; dabei steigt nämlich die Feldstärke, von der die Migration abhängt. Auch können bei derart geringen pin-Abständen Kurzschlüsse durch die Feuchtigkeit zustande kommen.

Der Erfindung liegt die Aufgabe zugrunde, einen Schutz vor Feuchtigkeitseinflüssen in anderer Weise vorzusehen, als er oben beschrieben wurde.

Das erfindungsgemäße verfahren zur Verhinderung oder Reduzierung von Feuchtigkeitseinflüssen besteht darin, daß der migrationsgefährdete Bereich erwärmt wird, insbesondere daß in der Nähe von feuchtigkeitsgefährdeten stellen Wärme erzeugt wird, um einen entstandenen Feuchtigkeitsniederschlag zu beseitigen oder das Entstehen eines Feuchtigkeitsniederschlags zu verhindern. Dies kann durch ein nur für die genannte Wärmeerzeugung vorgesehenes Schaltungselement (z.B. ohmscher Widerstand) erfolgen, der stets oder nur bei akuter Gefahr der Bildung eines Feuchtigkeitsniederschlags oder nachdem tatsächlich ein Feuchtigkeitsniederschlag aufgetreten ist, mit elektrischer Energie zwecks Wärmeerzeugung versorgt wird. Es erscheint auch nicht ausgeschlossen, daß ein in der Nähe des feuchtigkeitsgefährdeten Bereichs ohnehin vorhandenes elektrisches Bauelement, das bei normalem Betrieb nicht genügend Wärme zur Verhinderung des Feuchtigkeitsniederschlags abgibt, bei der Gefahr der Bildung eines Niederschlags oder bei bereits vorhandenem Niederschlag stärker mit elektrischer Energie beaufschlagt wird, um mehr Wärme zu erzeugen. Bei einem monolithischem Aufbau der elektronischen Baugruppe können Komponeneten wie z.B. ein Substrattransistor, eine Dielektrikumsschicht und/oder die Sperrschicht, die auch bei einer geeigneten Beschaltung zur Wärmeerzeugung dienen, dazu verwendet werden durch ihre Eigenerwärmung die Feuchtigkeit auf bzw. an der elektronischen Baugruppe zu beseitigen.

Die Aufgabe wird bei der Baugruppe erfindungsgemäß dadurch gelöst, daß in der Nähe eines feuchtigkeitsgefährdeten Bereichs der Baugruppe ein Schaltungselement angeordnet ist, dem elektrische Energie zum Zweck des Erwärmens des feuchtigkeitsgefährdeten Bereichs derart, daß ein gebildeter Feuchtigkeitsniederschlag verdunstet oder das Entstehen eines Feuchtigkeitsniederschlags durch das Erwärmen verhindert wird, zuführbar ist.

Bei der Erfindung kann sowohl die gesamte Baugruppe oder elektronische Schaltung vor Feuchtigkeit geschützt werden, oder es werden nur besonders gefährdete Stellen der Baugruppe bzw. Leiterplatte dadurch geschützt, daß in nächster Nähe dieser gefährdeten stelle ein Bauelement angeordnet wird, das in der Lage ist, Wärme zu erzeugen, um dadurch das Entstehen eines Feuchtigkeitsniederschlags zu verhindern oder einen bereits gebildeten Feuchtigkeitsniederschlag wieder zu entfernen. Durch verhindern bzw. Beseitigen der Betauung (Feuchtigkeitsniederschlag) wird auch eine wesentliche Fehlerquelle bei elektrischen oder elektronischen Baugruppen verhindert bzw. beseitigt.

Bei einfachen Konstruktionen kann das für diesen Zweck vorgesehene elektrische Bauelement ständig Wärme erzeugen. Aus Gründen der Energieeinsparung kann es jedoch zweckmäßig sein, gemäß einer Ausführungsform der Erfindung dafür zu sorgen, daß das genannte Bauelement nur dann Wärme erzeugt, wenn dies zur Verhinderung oder Beseitigung eines Feuchtigkeitsniederschlags erforderlich ist. Daher ist gemäß einer Ausführungsform der Erfindung ein Sensor vorgesehen, der Feuchtigkeit erkennt. Dies kann insbesondere ein Widerstandssensor oder ein Stromsensor sein, der bei vorhandener Feuchtigkeit zwischen zwei Elektroden einen endlichen Widerstand bzw. einen von Null verschiedenen Strom (Fehlerstrom) feststellt.

Bei speziellen Ausführungsformen der Erfindung wird somit an feuchtigkeitsempfindlichen Konfigurationen eine Fehlerstrom-Sensierung durchgeführt. Die Meßstelle oder die Meßstellen wird (werden) zweckmäßigerweise in der Nähe von z.B. hinsichtlich Migration sehr empfindlichen Schaltungskomponenten angebracht oder die empfindlichen Schaltungskomponenten werden zur Sensierung der Taupunktnähe mitbenutzt. Wird Feuchtigkeit festgestellt, so können entsprechende Gegenmaßnahmen (Heizen) eingeleitet werden. Dies wird z.B. durch partielle Erwärmung der Leiterplatte erreicht. Dies kann z.B. durch einen für diesen Zweck dort vorgesehenen ohmschen Widerstand und angemessene Beaufschlagung des genannten Widerstands mit elektrischer Energie erreicht werden. Es kann aber statt dessen durch die Plazierung von ohnehin vorhandenen, Wärme abgebenden Leistungsverbrauchern an geeigneter Stelle der Leiterplatte an den zu schützenden Stellen Wärme erzeugt werden. Auch können Bauteile die in der zu schützenden Baugruppe vorhanden sind auch dazu verwendet werden, daß sie durch ihre Erwärmung den Feuchtigkeitsniederschlag beseitigen. Dazu werden z.B. eine Substratdiode oder eine Substrattransistor oder eine Dieelektrikumsschicht derart betrieben, daß sie sich erwärmen und somit den Feuchtigkkeitsniederschlag beseitigen. Ist dieser Vorgang beendet können sie wieder ihren ursprünglichen Zweck in der Schaltung erfüllen, passiv geschaltet werden.

Vorteile der Erfindung liegen darin, daß man eine maximale Systemsicherheit erreicht, da die Störbeeinflussung und Funktionsstörungen, bedingt durch die Feuchtigkeit wie z.B. Migration, die an sich auf jeder Baugruppe oder Leiterplatte vorhanden ist, auf jeweils das erforderliche Minimum reduziert wird. Auf diese Weise können Systemausfälle wie z.B. ein Feinschluß, Kurzschluß, Unterbrechung ausgeschlossen bzw. reduziert werden.

Zur Erfindung gehören auch solche Ausführungsformen, bei denen die Gefahr der Bildung eines Feuchtigkeitsniederschlags ausschließlich aufgrund der herrschenden Temperatur (z.B. bei Temperaturen von weniger als 20 °C) festgestellt wird, und in diesem Fall kann der Heizvorgang in Abhängigkeit von der herrschenden Temperatur eingeleitet werden. Als Heizelement mag sich auch ein elektronisches Bauteil, insbesondere ein Transistor eignen, oder ein Leiterzug der Leiterplatte oder der monolithisch integrierten Schaltung.

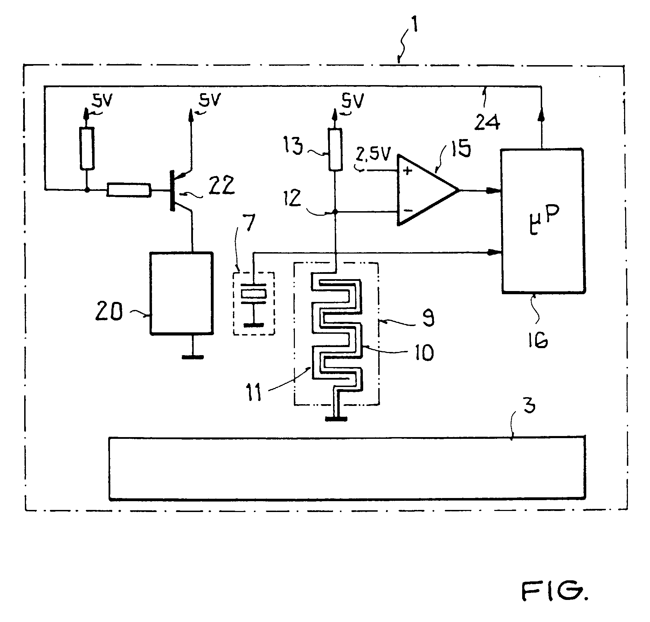

Weitere Merkmale und Vorteile der Erfindung ergeben sich aus der nachfolgenden Beschreibung eines Ausführungsbeispiels der Erfindung anhand der Zeichnung, die erfindungswesentliche Einzelheiten zeigt, und aus den Ansprüchen. Die einzelnen Merkmale können je einzeln für sich oder zu mehreren in beliebiger Kombination bei einer Ausführungsform der Erfindung verwirklicht sein.

Die einzige Figur zeigt eine auf einer Leiterplatte angeordnete elektronische Baugruppe aus dem Bereich der Kraftfahrzeugelektronik mit Elementen zum Sensieren eines Feuchtigkeitsniederschlags und zum partiellen Heizen der Leiterplatte.

Die Leiterplatte 1 ist in vereinfachter schematisierter Darstellung gezeigt. Sie weist einen Anschlußsteckerbereich mit einem Stecker 3 auf, mit dessen Hilfe die auf der Leiterplatte 1 angeordnete elektronische Schaltung mit Stromversorgungsleitungen und Signalleitungen der übrigen Kraftfahrzeugelektronik verbunden werden kann. Die Leiterplatte 1 trägt gedruckte oder geätzte Leiterzüge, von denen lediglich einige dargestellt sind.

Als Teil, das bezüglich Feuchtigkeit insbesondere bezüglich der Migration besonders empfindlich ist, ist ein Beschleunigungsaufnehmer 7 auf der Leiterplatte 1 angeordnet. Dieser dient dazu, im Betrieb den Aufprall des Kraftfahrzeugs auf ein Hindernis zu detektieren, um dadurch z.B. einen Airbag, der zum Schutz des Fahrers vorgesehen ist, zu aktivieren. Dicht neben dem Beschleunigungsaufnehmer 7 ist ein Stromsensor 9, und zwar ein Leckstromsensor, der als Feuchtigkeitssensor wirkt, vorgesehen. Dieser weist eine mäanderförmige, mit Masse verbundene Masseleitung 10 auf, und in einem kleinen Abstand von dieser ist eine Leitung 11 angeordnet Die Leiter 10 und 11 stehen mit der Umgebung in Verbindung, sind also insbesondere nicht durch eine Lackierung geschützt. Wenn sich infolge von Taubildung Feuchtigkeit auf dem Stromsensor 9 niederschlägt, so nimmt der ohmsche Widerstand zwischen den Leitungen 10 und 11 ab, und das Potential an einem Anschluß 12 des Stromsensors sinkt ab. Der Anschluß 12 ist über einen Widerstand 13 mit einer positiven Versorgungsspannung von z.B. 5 V verbunden, die in nicht gezeigter Weise vom Stecker 3 zugeführt wird. statt dessen könnte sie aus einer vom Stecker 3 zugeführten Gleichspannung auf der Leiterplatte 1 durch einen geeigneten Spannungsregler erzeugt werden. Die Anordnung ist so getroffen, daß dann, wenn das Potential am Anschluß 12 den Wert von 2,5 V überschreitet, ein Komparator 15 ein Signal an einen Steuereingang eines Mikroprozessors 16 abgibt, der eine Heizung in nächster Nähe des Beschleunigungsaufnehmers 7 und des Stromsensors 9 in Betrieb setzt. Hierzu ist in nächster Nähe der genannten Elemente als Heizelement 20 z. B. ein ohmscher Widerstand vorgesehen, das einerseits mit Masse verbunden ist und andererseits über eine steuerbare Schaltereinrichtung, im Beispiel einen Transistor 22, an die Spannung von 5 V gelegt werden kann. Der Transistor 22 wird an seiner Steuerelektrode von dem Mikroprozessor 16 über eine Steuerleitung 24 angesteuert, wenn, wie oben beschrieben, der Stromsensor 9 Feuchtigkeit festgestellt hat.

Wenn das Heizelement 20 in Betrieb ist, erwärmt es die Leiterplatte 1 in seiner Umgebung und verhindert oder beseitigt somit Tau im Bereich des Beschleunigungsaufnehmers und im Bereich des Stromsensors 9. Letzteres ist zweckmäßig und wichtig, damit das Heizelement 20 durch den Mikroprozessor auch wieder abgeschaltet ist, wenn der Feuchtigkeitsniederschlag auf dem Stromsensor 9 verschwunden ist.

Beim Kondensieren von Wasserdampf auf den zu schützenden Bereich bei unter 0 °C-Oberflächentemperatur bildet sich ein unschädlicher, isolierender Eisfilm. Steigt die Temperatur über 0 °C an, so muß die oben beschriebene Schutzwirkung einsetzen, da dann das Eis schmilzt und seine isolierenden Eigenschaften verliert.

Weiter Anwendungsbeispiele ergeben sich wenn das Heizelement 20 kein separates Bauteil ist, dessen einzige Aufgabe die Erwärmung ist sondern hierbei kann es sich auch um ein Bauelement handeln welches bereits in der Baugruppe mit einer anderen Funktion bedacht ist. Wird aber diese Funktion zeitweise nicht benötigt kann es auch als Heizelement betrieben werden. Auch kann ein solches Bauteil automatisch und ständig durch seine andauernde verlustleistungserzeugung als Heizelement, verwendet werden. Dabei ist es unwesentlich ob es sich um eine monolithisch aufgebaute Baugruppe handelt bei der z.B. eine bereits vorhandene Substratdiode oder eine speziell hierfür benötigte Substratdiode die Heizfunktion mitübernimmt oder ob es sich um eine Leiterplatte handelt bei der z.B. ein bereits vorhandener Widerstand oder ein speziell hierfür angebrachter Widerstand zum Heizen verwendet wird. Als Bauteile, die auch zur Erwärmung verwendet werden können, sind z.B. Dioden, Widerstände und Transistoren zu nennen. Auch können bei entsprechendem Betrieb Dielektrika und Sperrschichten im Substrat zu Erwärmung verwendet werden.

Der Vollständigkeit halber muß noch erwähnt werden, daß für die andere Funktionen, wie z.B. die Temperaturmessung oder Feuchtemessung kein extra Bauteil in der Schaltung zwingend benötigt wird, sondern diese Funktion auch von einem bereits vorhandenen Bauteil übernommen werden kann. Als Beispiel soll hier eine Diode genannt werden, an deren Spannung auch die Temperatur abgeleitet werden kann, so daß sie zusätzlich zu einer anderen Funktion in der Baugruppe auch zeitweise die Funktion eines Temperatursensor erfüllen kann. Auch kann an der Kapazität eines bereits vorhandenen Kondensators die Feuchtigkeit bestimmt werden, so daß dieser zeitweise auch als Feuchtigkeitssensor eingesetzt wird. Für die Funktionen in der Figur abgebildeten Bausteine können auch bereits in der Baugruppe vorhandene Bausteine zumindest zeitweise verwendet werden.

## Patentansprüche

1. Verfahren zum Verhindern, Verringern oder Abstellen von Feuchtigkeitseinflüssen in einem feuchtigkeitsgefährdeten Bereich einer elektrischen oder elektronischen Baugruppe, dadurch gekennzeichnet, daß der feuchtigkeitsgefährdete Bereich erwärmt wird, derart, daß ein gebildeter Feuchtigkeitsniederschlag verdunstet oder das Entstehen eines Feuchtigkeitsniederschlags durch das Erwärmen verhindert wird.

2. Elektrische oder elektronische Baugruppe mit einer Leiterplatte, die elektrische und/oder elektronische Bauelemente trägt, bei der oder/und bei denen Mittel zum verhindern oder verringern von Feuchtigkeit von leitendem Material vorgesehen sind, dadurch gekennzeichnet, daß in der Nähe eines feuchtigkeitsgefährdeten Bereichs der Baugruppe ein Schaltungselement (20) angeordnet ist, dem elektrische Energie zum Zweck des Erwärmens des feuchtigkeitsgefährdeten Bereichs derart, daß ein gebildeter Feuchtigkeitsniederschlag verdunstet oder das Entstehen eines Feuchtigkeitsniederschlags durch das Erwärmen verhindert wird, zuführbar ist.

3. Baugruppe nach Anspruch 2, dadurch gekennzeichnet, daß in der Nähe des feuchtigkeitsgefährdeten Bereichs ein Feuchtigkeitssensor vorgesehen ist, und daß eine Vorrichtung vorgesehen ist, die beim Erkennen von Feuchtigkeit durch den Feuchtigkeitssensor dem genannten Schaltungselement elektrische Energie zwecks Wärmeerzeugung zuführt.

4. Baugruppe nach Anspruch 3, dadurch gekennzeichnet, daß der Feuchtigkeitssensor ein Stromsensor (9) ist.

5. Baugruppe nach Anspruch 3, dadurch gekennzeichnet, daß der Feuchtigkeitssensor ein Widerstandssensor ist.

6. Baugruppe nach Anspruch 2, dadurch gekennzeichnet, daß ein Temperatursensor vorgesehen ist, und daß eine Vorrichtung vorgesehen ist, die beim Erkennen des Unterschreitens einer vorgegebenen Temperatur dem genannten Schaltungselement elektrische Energie zwecks Wärmeerzeugung zuführt.

7. Baugruppe nach einem der Ansprüche 3 bis 6, dadurch gekennzeichnet, daß der Feuchtigkeitssensor, Stromsensor, Widerstandssensor bzw. Temperatursensor in einem von dem genannten Schaltungselement (20) erwärmbaren Bereich angeordnet ist.
